**Europäisches Patentamt**

**European Patent Office**

**Office européen des brevets**

(19)

(11) Veröffentlichungsnummer: **0 043 009**
**B1**

(12) # EUROPÄISCHE PATENTSCHRIFT

(45) Veröffentlichungstag der Patentschrift:
**02.05.85**

(51) Int. Cl.⁴: **H 01 L 29/743,** H 01 L 27/06

(21) Anmeldenummer: **81104472.6**

(22) Anmeldetag: **10.06.81**

(54) **Steuerbarer Halbleiterschalter.**

(30) Priorität: **26.06.80 DE 3024015**

(43) Veröffentlichungstag der Anmeldung:
**06.01.82 Patentblatt 82/1**

(45) Bekanntmachung des Hinweises auf die Patenterteilung:
**02.05.85 Patentblatt 85/18**

(84) Benannte Vertragsstaaten:
**CH DE FR GB IT LI SE**

(56) Entgegenhaltungen:
**EP - A - 0 017 980**
**DE - A - 2 205 307**
**DE - A - 2 625 917**

**Patent Abstracts of Japan Vol. 4, No. 157, 4. November 1980 page 154E32**

(73) Patentinhaber: **Siemens Aktiengesellschaft, Berlin und München Wittelsbacherplatz 2, D-8000 München 2 (DE)**

(72) Erfinder: **Leipold, Ludwig, Dipl.-Ing., Kurt-Eisner-Strasse 41, D-8000 München 83 (DE)**
Erfinder: **Stengl, Jens Peer, Gunterstrasse 13, D-8000 München 19 (DE)**
Erfinder: **Tihanyi, Jenö, Dr., Wolfratshauser Strasse 179 b, D-8000 München 71 (DE)**

ACTORUM AG

## Beschreibung

Die vorliegende Erfindung bezieht sich auf einen steuerbaren Halbleiterschalter mit einem Halbleiterkörper, enthaltend eine Thyristorstruktur mit einer ersten Zone vom ersten Leitfähigkeitstyp, die planar in eine zweite Zone vom zweiten Leitfähigkeitstyp eingebettet ist, enthaltend eine dritte Zone vom ersten Leitfähigkeitstyp und eine vierte Zone vom zweiten Leitfähigkeitstyp, enthaltend weiter einen in den Halbleiterkörper integrierten MIS-FET, dessen Source-Zone vom ersten Leitfähigkeitstyp ist und die planar in eine Zone vom zweiten Leitfähigkeitstyp eingebettet ist, mit einer Steuerelektrode, die auf einer auf der Oberfläche des Halbleiterkörpers liegenden Isolierschicht angeordnet ist und eine dem FET zugeordnete erste Kanalzone überdeckt, und mit einer Katodenelektrode auf dem Halbleiterkörper.

Ein solcher Halbleiterschalter ist beispielsweise in der DE-OS 2 625 917 beschrieben worden. Dieser Halbleiterschalter ist ein abschaltbarer Thyristor, in dessen Halbleiterkörper ein Feldeffekt-Transistor (FET) integriert ist. Zum Ansteuern des FET ist eine gegen die Oberfläche des Halbleiterkörpers isolierte Steuerelektrode vorgesehen. Zum Abschalten des eingeschalteten Thyristors wird der FET leitend gesteuert und stellt einen Kurzschluss zwischen der katodenseitigen Emitterzone und der katodenseitigen Basiszone her. Dann fliesst der Thyristorstrom teilweise unter Umgehung der katodenseitigen Emitterzone in die Kurzschlüsse ab. Die Ladungsträgeremission aus der Katodenzone wird damit herabgesetzt. Um den Thyristor auszuschalten, muss ein gewisser Anteil der aktiven Thyristorfläche kurzgeschlossen werden. Um diesen Anteil vermindert sich die Stromtragfähigkeit des Thyristors. Zum Einschalten weist der Thyristor eine andere Steuerelektrode auf, durch die in bekannter Weise Steuerstrom in den Halbleiterkörper injiziert werden kann. Dieser Steuerstrom liegt in der Regel zwischen 10 und 100 mA. Eine direkte Ansteuerung durch Mikroprozessoren oder LSI-Schaltungen kommt daher nicht in Betracht. Zu den direkt durch Mikroprozessoren ansteuerbaren Halbleiterschaltern gehören die in letzter Zeit bekanntgewordenen Leistungs-MIS-FET. Diese MIS-FET haben jedoch einen relativ hohen Einschaltwiderstand, der um so höher liegt, je höher die zu schaltende Spannung ist. Bei einem MIS-FET für zum Beispiel 500 V liegt dieser Einschaltwiderstand zwischen 1 und 5 Ohm. Bei hohem Strom wird daher eine recht beträchtliche Verlustleistung im Transistor umgesetzt, die durch Kühlung abgeführt werden muss.

Der Erfindung liegt die Aufgabe zugrunde, einen abschaltbaren Halbleiterschalter der eingangs erwähnten Art so weiterzubilden, dass er fast leistungslos ansteuerbar ist und ausserdem einen sehr geringen Einschaltwiderstand aufweist.

Die Erfindung ist gekennzeichnet durch folgende Merkmale:

a) Die dem MIS-FET zugeordnete eine Zone vom zweiten Leitfähigkeitstyp ist planar in die dritte Zone eingebettet und bildet an der Oberfläche des Halbleiterkörpers die erste Kanalzone,

b) die zweite Zone der Thyristorstruktur ist planar in die dritte Zone eingebettet und bildet an der Oberfläche eine zweite Kanalzone,

c) zwischen den beiden Kanalzonen tritt die dritte Zone an die Oberfläche des Halbleiterkörpers,

d) die Steuerelektrode überdeckt auch die zweite Kanalzone und den an die Oberfläche tretenden Teil der dritten Zone,

e) die Katodenelektrode ist mit der Source-Zone des MIS-FET kontaktiert.

Weiterbildungen der Erfindung sind Gegenstand der Unteransprüche.

Die Erfindung wird an Hand zweier Ausführungsbeispiele in Verbindung mit den Fig. 1 bis 3 näher erläutert. Es zeigen:

Fig. 1 und 2 den Schnitt durch einen Halbleiterkörper eines ersten Halbleiterschalters in zwei verschiedenen Betriebszuständen und

Fig. 3 den Schnitt durch einen Halbleiterkörper eines zweiten Halbleiterschalters gemäss der Erfindung.

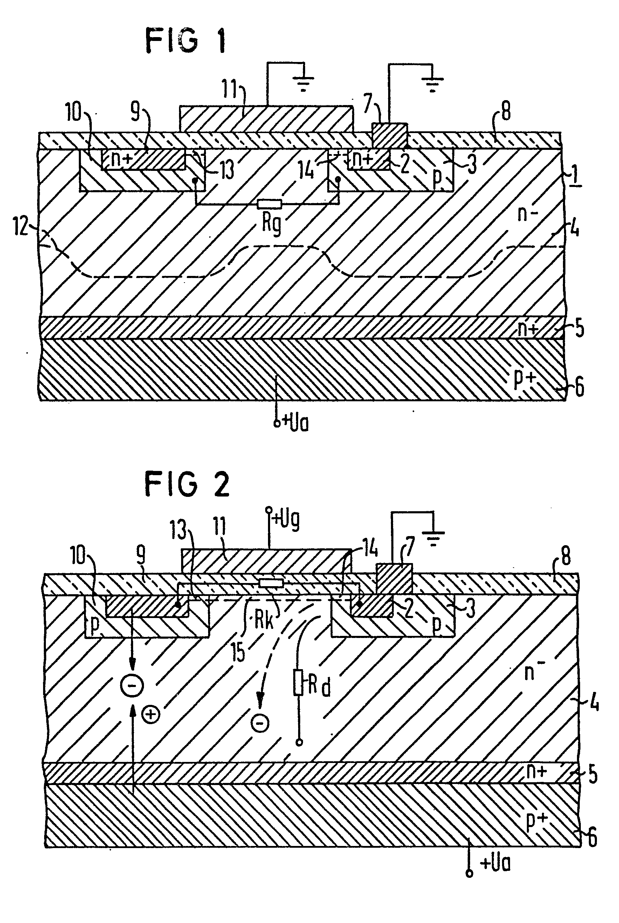

Der Halbleiterschalter nach Fig. 1 hat einen Halbleiterkörper 1, der eine Thyristorstruktur und einen FET aufweist. Der FET hat eine Source-Zone 2, die planar in eine Zone 3 des entgegengesetzten Leitfähigkeitstyps eingebettet ist. Die Zone 3 wiederum ist planar in eine dritte Zone 4 des Halbleiterkörpers 1 eingebettet. Die Zone 3 reicht daher bis an die Oberfläche des Halbleiterkörpers und ist dazu bestimmt, eine leitende Schicht des FET zu bilden. Die dritte Zone 4 dient als Drain-Zone des FET. Sie ist im Ausführungsbeispiel schwach n-dotiert, die Zone 3 ist p-dotiert und die Zone 2 ist stark n-dotiert.

Die Thyristorstruktur besteht aus einer ersten Zone 9, die in eine zweite Zone 10 planar eingebettet ist. Die zweite Zone 10 wiederum ist planar in die dritte Zone 4 eingebettet, die der Thyristorstruktur und dem FET gemeinsam angehört. Die vierte Zone der Thyristorstruktur wird durch die Zone 6 gebildet. Die erste Zone 9 ist die katodenseitige Emitterzone, die Zone 10 die katodenseitige Basiszone, die Zone 4 die anodenseitige Basiszone und die Zone 6 die anodenseitige Emitterzone. Die Dotierung der genannten Zonen ist im Ausführungsbeispiel $n^+pn^-p^+$. Zwischen den Zonen 4 und 6 kann noch ein stark n-dotierter Bereich 5 vorgesehen sein, dessen Funktion weiter unten erläutert werden wird. Die Zone 10 reicht bis an die Oberfläche des Halbleiterkörpers und ist zur Bildung einer zweiten Kanalzone bestimmt.

Die Oberfläche des Halbleiterkörpers ist mit einer Isolierschicht 8, zum Beispiel aus $SiO_2$, versehen, auf der eine Steuerelektrode 11 angeordnet ist. Die Steuerelektrode 11 überdeckt die Kanalzonen 13, 14 der Zonen 3 und 10 und den zwischen den Kanalzonen an die Oberfläche des Halbleiterkörpers tretenden Bereich der Zone 4. Die Source-Zone 2 ist mit einer Elektrode 7 kontaktiert, die die Funktion einer Katodenelektrode übernimmt. Sie kann gleichzeitig auch die Zone 3 des FET kontaktieren. Zwischen den Zonen 3 und 10 ist noch ein Widerstand $R_g$ eingezeichnet, durch den die Zone 10 auf festes Potential gelegt wird. Dieser Widerstand kann entweder extern dargestellt werden oder durch einen die Zonen 10 und 3 verbindenden Steg des gleichen Leitfähigkeitstyps.

In Fig. 1 liegt die Steuerelektrode 11 auf dem gleichen Potential wie die Katodenelektrode 7. Bei der eingezeichneten Polarität der Anodenspannung $U_a$ ist der Schalter in Blockierrichtung (Vorwärtsrichtung) vorgespannt und der pn-Übergang zwischen den Zonen 3 und 4 ist gesperrt. Dabei bildet sich eine Raumladungszone aus, deren Grenze mit 12 bezeichnet ist. Wird an die Elektrode 11 eine positive Spannung $+ U_g$ gelegt (Fig. 2), so bilden sich in den Kanalzonen 13, 14 Inversionsschichten aus, die n-leitende Kanäle zwischen den Zonen 2 und 4 beziehungsweise 4 und 9 darstellen. Zwischen den Kanalzonen 13 und 14 kommt es unterhalb der Steuerelektrode in der Zone 4 zur Bildung einer Anreicherungsschicht 15 aus negativen Ladungsträgern, so dass sich zwischen den Zonen 2 und 9 eine gut leitende, rein ohmsche Verbindung einstellt. Dann liegt die Zone 9 praktisch auf Katodenpotential. Damit kann eine Emission von negativen Ladungsträgern aus der Zone 9 in die Zone 4 beginnen, die eine Emission von positiven Ladungsträgern aus der Zone 6 verursacht. Dieser Vorgang schaukelt sich so lange auf, bis der pn-Übergang zwischen den Zonen 10 und 4 in Durchlassrichtung gepolt ist und die Thyristorstruktur zündet.

Gleichzeitig wird natürlich auch ein gewisser Fluss von negativen Ladungsträgern aus der Zone 2 in Richtung zur Anode stattfinden, wie dies durch den gestrichelten Pfeil angedeutet ist. Der Widerstand, den die Elektronen hier vorfinden, ist mit $R_d$ symbolisiert. Er ist wesentlich höher als derjenige Widerstand, den diejenigen Ladungsträger vorfinden, die durch die Schicht 15 ihren Weg über die Thyristorstruktur nehmen. Der Widerstand im Kanal 15 ist mit $R_k$ symbolisiert.

Soll der Schalter ausgeschaltet werden, so wird die Steuerspannung weggenommen. Damit löst sich die Schicht 15 auf und die Inversionsschichten in den Kanalzonen 13 und 14 verschwinden. Damit wird der Stromfluss zur Thyristorstruktur unterbrochen und sie geht in den gesperrten Zustand über. Die im Halbleiterkörper gespeicherten positiven und negativen Ladungsträger verschwinden dabei durch Rekombination. Die Rekombinationsgeschwindigkeit kann dadurch erhöht werden, dass zwischen die Zonen 4 und 6 die stark n-dotierte Zone 5 eingebaut wird. Die Dotierung der Zonen 5 und 6 kann gleich hoch sein. Kann eine längere Abklingzeit des Stroms in Kauf genommen werden, so ist die Zone 5 entbehrlich, was zugleich den Vorteil hat, dass der Halbleiterschalter auch in Rückwärtsrichtung höhere Spannungen sperren kann.

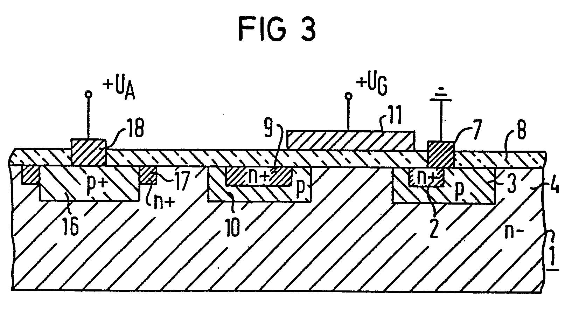

In Fig. 3 ist ein abschaltbarer Halbleiterschalter dargestellt, der sich von dem in Fig. 1 und 2 beschriebenen durch seinen lateralen Aufbau unterscheidet. Gleiche oder funktionsgleiche Teile wie in Fig. 1 und 2 sind gleich bezeichnet. Die anodenseitige Emitterzone (4. Zone) der Thyristorstruktur trägt die Bezugsziffer 16 und liegt an derjenigen Oberfläche des Halbleiterkörpers 1, die den Katodenkontakt 7 trägt. Sie ist zweckmässigerweise auf der von FET 2, 3, 4 abgewandten Seite der Zonen 9 und 10 angeordnet. Die Zone 16 ist wie auch die anderen Zonen planar in die Oberfläche des Halbleiterkörpers 1 eingelassen. Die Zone 16 trägt einen Anodenkontakt 18. Sie kann von einer hochdotierten Zone 17 umgeben sein, die die gleiche Funktion wie die Zone 5 nach Fig. 1 und 2 hat.

Es wurde gefunden, dass der Einschaltwiderstand einer Ausführungsform des beschriebenen Halbleiterschalters, der zum Beispiel für 500 V und 10 A ausgelegt war, nur einige Zehntel Ohm betrug. Damit liegt der Einschaltwiderstand um etwa eine Grössenordnung unter dem eines Feldeffekt-Transistors.

**Patentansprüche**

1. Steuerbarer Halbleiterschalter mit einem Halbleiterkörper, enthaltend eine Thyristorstruktur mit einer ersten Zone vom ersten Leitfähigkeitstyp, die planar in eine zweite Zone vom zweiten Leitfähigkeitstyp eingebettet ist, enthaltend eine dritte Zone vom ersten Leitfähigkeitstyp und eine vierte Zone vom zweiten Leitfähigkeitstyp, enthaltend weiter einen in den Halbleiterkörper integrierten MIS-FET, dessen Source-Zone vom ersten Leitfähigkeitstyp ist und die planar in eine Zone vom zweiten Leitfähigkeitstyp eingebettet ist, mit einer Steuerelektrode, die auf einer auf der Oberfläche des Halbleiterkörpers liegenden Isolierschicht angeordnet ist und eine dem FET zugeordnete erste Kanalzone überdeckt, und mit einer Katodenelektrode auf dem Halbleiterkörper, gekennzeichnet durch die Merkmale:

a) Die dem MIS-FET zugeordnete eine Zone (3) vom zweiten Leitfähigkeitstyp ist planar in die dritte Zone (4) eingebettet und bildet an der Oberfläche des Halbleiterkörpers die erste Kanalzone (14),

b) die zweite Zone (10) der Thyristorstruktur ist planar in die dritte Zone (4) eingebettet und bildet an der Oberfläche eine zweite Kanalzone (13),

c) zwischen den beiden Kanalzonen (13, 14) tritt die dritte Zone an die Oberfläche des Halbleiterkörpers (1),

d) die Steuerelektrode (11) überdeckt auch die zweite Kanalzone (13) und den an die Oberfläche tretenden Teil der dritten Zone (4),

e) die Katodenelektrode (7) ist mit der Source-Zone (2) des MIS-FET kontaktiert.

2. Halbleiterschalter nach Anspruch 1, dadurch gekennzeichnet, dass die Katodenelektrode (7) auch die dem FET zugeordnete eine Zone (3) vom zweiten Leitfähigkeitstyp kontaktiert.

3. Halbleiterschalter nach Anspruch 1 oder 2, dadurch gekennzeichnet, dass die vierte Zone (6) auf der der Katodenelektrode (7) abgewandten Seite des Halbleiterkörpers (1) angeordnet ist.

4. Halbleiterschalter nach Anspruch 3, dadurch gekennzeichnet, dass die dritte Zone (4) einen hochdotierten Bereich (5) vom ersten Leitfähigkeitstyp hat, der an die vierte Zone (6) angrenzt.

5. Halbleiterschalter nach Anspruch 1 oder 2, dadurch gekennzeichnet, dass die vierte Zone (16) auf derjenigen Seite in den Halbleiterkörper (1) eingebettet ist, die die Katodenelektrode (7) trägt.

6. Halbleiterschalter nach Anspruch 5, dadurch gekennzeichnet, dass die vierte Zone (16) von einem hochdotierten Bereich (17) vom ersten Leitfähigkeitstyp umgeben ist, der in die dritte Zone (4) eingebettet ist.

## Claims

1. A controlled semiconductor switch comprising a semiconductor body, containing a thyristor structure having a first zone of the first conductivity type which is embedded in planar manner in a second zone of the second conductivity type, a third zone of the first conductivity type and a fourth zone of the second conductivity type, and further containing a MIS-FET which is integrated into the semiconductor body and the source zone of which is of the first conductivity type and is embedded in planar manner in a zone of the second conductivity type, having a control electrode which is arranged on an insulating layer positioned on the surface of the semiconductor body and which covers a first channel zone assigned to the FET, and having a cathode electrode on the semiconductor body, characterised by the features:

a) the one zone (3) of the second conductivity type which is assigned to the MIS-FET, is embedded in the third zone (4) in planar fashion and forms the first channel zone (14) at the surface of the semiconductor body,

b) the second zone (10) of the thyristor structure is embedded in the third zone (4) in planar fashion and forms a second channel zone (13) at the surface,

c) the third zone appears at the surface of the semiconductor body (1) between the two channel zones (13, 14),

d) the control electrode (11) also covers the second channel zone (13) and the part of the third zone (4) which appears on the surface, and

e) the cathode electrode (7) contacts the source zone (2) of the MIS-FET.

2. A semiconductor switch as claimed in Claim 1, characterised in that the cathode electrode (7) also contacts the one zone (3) of the second conductivity type which is assigned to the FET.

3. A semiconductor switch as claimed in Claim 1 or Claim 2, characterised in that the fourth zone (6) is arranged on the side of the semiconductor body (1) which faces away from the cathode electrode (7).

4. A semiconductor switch as claimed in Claim 3, characterised in that the third zone (4) has a highly doped region (5) of the first conductivity type bordering on the fourth zone (6).

5. A semiconductor switch as claimed in Claim 1 or Claim 2, characterised in that the fourth zone (16) is embedded in the semiconductor body (1) at the side which carries the cathode electrode (7).

6. A semiconductor switch as claimed in Claim 5, characterised in that the fourth zone (16) is surrounded by a highly doped region (17) of the first conductivity type which is embedded in the third zone (4).

## Revendications

1. Commutateur à semiconducteurs pouvant être commandé comportant un corps semiconducteur, incluant une structure de thyristor possédant une première zone d'un premier type de conductivité, qui est insérée selon le mode planar dans une seconde zone possédant le second type de conductivité, et incluant une troisième zone possédant le premier type de conductivité et une quatrième zone possédant le second type de conductivité, et incluant en outre un transistor MIS-FET intégré dans le corps semiconducteur et dont la zone de source possède le premier type de conductivité et est insérée selon le mode planar dans une zone possédant le second type de conductivité, et comportant une électrode de commande qui est disposée sur une couche isolante située sur la surface du corps semiconducteur et recouvre une première zone de canal associée au transistor FET, et comportant une électrode formant cathode située sur le corps semiconducteur, remarquable par les caractéristiques suivantes:

a) la première zone (3) possédant le second type de conductivité et associée au transistor MIS-FET, est réalisée selon le mode planar dans la troisième zone (4) et forme la première zone de canal (14) au niveau de la surface du corps semiconducteur,

b) la seconde zone (10) de la structure du thyristor est insérée selon le mode planar dans la troisième zone (4) et forme une seconde zone de canal (13) au niveau de la surface,

c) la troisième zone est située au niveau de la surface du corps semiconducteur (1) entre les deux zones de canal (13, 14),

d) l'électrode de commande (11) recouvre également la seconde zone de canal (13) et la partie, qui est située au niveau de la surface, de la troisième zone (4),

e) l'électrode formant cathode (7) est contactée par la zone formant source (2) du transistor MIS-FET.

2. Commutateur à semiconducteurs selon la revendication 1, caractérisé par le fait que l'électrode formant cathode (16) contacte également la première zone (3) possédant le second type de conductivité et associée au transistor FET.

3. Commutateur à semiconducteurs suivant la revendication 1 ou 2, caractérisé par le fait que la quatrième zone (6) est disposée sur le côté du corps semiconducteur (1) qui est tourné à l'opposé de l'électrode formant cathode (7).

4. Commutateur à semiconducteurs suivant la revendication 3, caractérisé par le fait que la troisième zone (4) possède une zone fortement dopée (5) possédant le premier type de conductivité et qui jouxte la quatrième zone (6).

5. Commutateur à semiconducteurs suivant la revendication 1 ou 2, caractérisé par le fait que la quatrième zone (16) est insérée sur la face du corps semiconducteur (1), qui porte l'électrode formant cathode (7).

6. Commutateur à semiconducteurs suivant la revendication 5, caractérisé par le fait que la quatrième zone (16) est entourée par une zone fortement dopée (17) possédant le premier type de conductivité et qui est insérée dans la troisième zone (4).

## FIG 1

## FIG 2

# FIG 3